Europäisches Patentamt

European Patent Office

Office européen des brevets

(19)

(11) Publication number: **0 147 968**

**A2**

# (12) EUROPEAN PATENT APPLICATION

(21) Application number: **84308559.8**

(22) Date of filing: **10.12.84**

(51) Int. Cl.⁴: **G 11 C 19/08**

(30) Priority: **23.12.83 US 564963**

(43) Date of publication of application:
**10.07.85 Bulletin 85/28**

(84) Designated Contracting States:
**DE FR GB**

(71) Applicant: **GENERAL MOTORS CORPORATION**
**General Motors Building 3044 West Grand Boulevard**
**Detroit Michigan 48202(US)**

(72) Inventor: **Ruch, David Edward**
**5676 Via Salerno**
**Goleta California 93117(US)**

(74) Representative: **Denton, Michael John et al,**
**Patent Section - Luton Office (F6) Vauxhall Motors**
**Limited P.O. Box 3 Kimpton Road**
**Luton Bedfordshire LU2 0SY(GB)**

(54) **Temperature compensated magnetic bubble memory.**

(57) A temperature compensated bubble memory system comprising a magnetic bubble memory module including at least one bubble memory device, a temperature sensor (10) producing an output current proportional to the temperature of said device, said device including X, Y, and Z coils, a sense amplifier (12) responsive to the output of said device and producing a logic level output based on a comparison of the output of the device with a threshold level, said device inducing a plurality of function elements (16), temperature compensation circuitry (14) responsive to the output of said sensor for adjusting the threshold level of said sense amplifier and the amount of current supplied to said function elements, means (20) responsive to said sensor output for determining whether the temperature of said device is within a predetermined operating range and if so providing the correct bias current to said Z coil and the correct drive currents to said X and Y coils.

Fig.2.

EP 0 147 968 A2

## TEMPERATURE COMPENSATED MAGNETIC BUBBLE MEMORY

This invention relates to magnetic bubble memories and more particularily to a bubble memory which is compensated for temperature changes.

In spite of the many advantages of bubble memories as bulk storage media, the question of satisfactory operation over the wide temperature range characteristic of military environments has been a matter of great concern. This is essentially the only significant challenge to a successful bubble memory system mechanization. There are a number of bubble memory parameters which vary with temperature. These include Bias Field, Sense Threshold, X Drive, Y Drive, Generate, Swap, Replicate Cut, and Replicate Transfer (through the generators for Swap and Replicate Transfer are essentially flat with temperature). Indeed these parameters are not temperature independent, so varying one parameter may affect the temperature characteristics of others.

The present invention is concerned with providing a magnetic bubble memory which is operable over a wider range of temperature than is possible with fixed operating parameters.

To this end, a temperature compensated bubble memory system in accordance with the present invention is characterised by the features specified in the characterising portion of claim 1. This invention provides a magnetic bubble memory which is compensated for parameter variations due to temperature changes, and wherein operation is inhibited when predetermined temperature limits are exceeded.

To attain the above objects, according to one aspect of the invention, one or more magnetic bubble memory (MBM) devices are mounted on a common heatsink so each device is close to the same temperature. A temperature sensor is attached to the heatsink and develops an analogue output current, related to temperature, which is converted to a voltage and controls temperature compensation circuitry. This circuitry includes function generators which produce voltage commands for the functions Generate, Swap, Replicate Cut, and Replicate Transfer (though the generators for Swap and Replicate Transfer may be omitted if desired). These commands are based on a known relationship between these functions and temperature. Function drivers respond to the voltage commands to produce current commands for the MBM devices. The temperature compensation circuitry also supplies a temperature compensated reference voltage to establish the logic "1" threshold level. The voltage output of the temperature sensor is also fed to an analogue to digital converter which provides an input to a microprocessor which accesses a lookup table stored in a Read Only Memory (ROM) of the microprocessor. A digital to analogue (D/A) converter responds to the ROM value supplied by the microprocessor to provide an input voltage to a current source which generates a current proportional to the output voltage and polarity of the D/A converter. The current source supplies this current to the Z coil of the MBM device to compensate the bias current for temperature variations. The ROM based values are also used to control a programmable power supply which supplies a voltage to X coil and Y coil drivers. These coil drivers provide output currents of triangular waveform and in quadrature for application to the X and

Y coils of the MBM devices.

This invention is further described by way of example with reference to the accompanying drawings in which:-

Figure 1 shows the functional architecture of a bubble memory device;

Figure 2 is a block diagram of the bubble memory temperature compensation circuitry; and

Figure 3A-3H are plots of bubble memory parameters as a function of temperature.

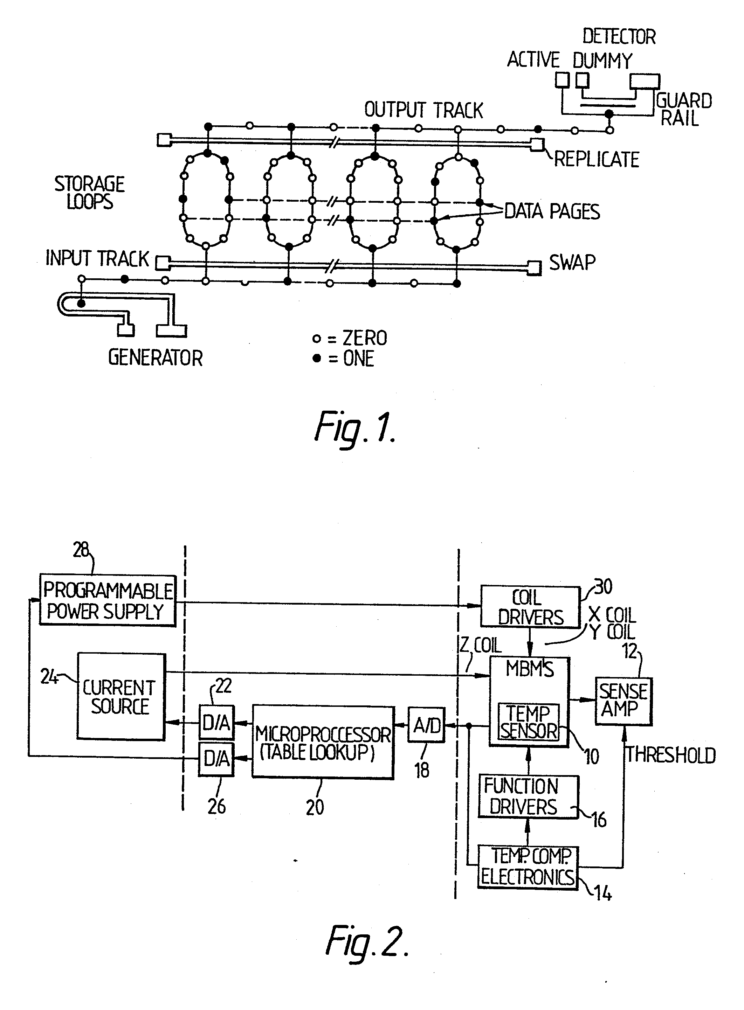

Referring now to the drawings and initially to Figure 1, the basic architecture of a bubble memory device is shown. For clarity, the use of odd and even storage loops is not shown. To use a bubble memory, the generation, transfer, detection, and replication of magnetic bubbles must be controlled. These control functions are performed utilizing the magnetic field produced by current pulses in variously shaped electrically conducting structures formed photolithographically on the device surface. For example, bubbles are generated by applying a current pulse to the GENERATE element. These bubbles are shifted along the input track until the whole page lines up with the minor loops. At this point, the page is transferred to the storage loops by applying a current pulse to the SWAP element.

To read data from the bubble memory, the storage loops are shifted until the desired page of data is next to the output track. At this point, a current pulse is applied to the REPLICATE element to transfer the data to the output track. The bubbles are shifted along the track to the DETECTOR, where they are detected as data. The replication process forms a copy of the bubble in the output track and, therefore, the readout is nondestructive (NDRO). Detection, or readout, of a bubble utilizes the magnetoresistive characteristic of permalloy (resistance is a function of the applied magnetic field). A resistor bridge compares the resistance of a detector element to that of a dummy element containing no bubbles. The detector bridge produces a 5-millivolt differential signal imposed on a substantially higher common-mode signal produced by the rotating field.

Bubble memory chips are designed with more loops than required. This allows the chip to be used with a few defective loops. Inclusion of these redundant loops increases the yield and lowers the costs. There is a small penalty in data rate due to the unused minor loops.

All information on useable bubble storage loops is kept in a programmable read only memory (PROM) on each Bubble Memory Module. The PROM outputs are loaded into parallel-to-serial registers which are serially connected to a bubble memory controller, which uses the data to skip bad loops in the bubble devices.

As shown in Figure 2, each Bubble Memory Module (MBM) has a sensor 10 that produces a voltage proportional to the temperature. This voltage is used directly on the Bubble Memory Module to vary function currents (generate, replicate, etc.) and sense amplifier threshold. An analogue to digital (A/D) converter 18 in the System Controller converts this temperature-voltage to digital form, which the microprocessor 20 uses for a table look-up. If the temperature is in the operating range, the microprocessor 20 sends commands, via digital to analogue (D/A) converters 22,26, to the system power supply, which produces the correct bias current and rotating magnetic field for the bubbles. If the temperature is not in the correct range, the microprocessor 20 inhibits all bubble operations and sends a temperature status error to the host computer.

The control circuitry for the magnetic bubble memory (MBM) devices includes a temperature sensor 10. Each MBM device is preferably mounted on a common heatsink to maintain each device close to the same temperature and the sensor 10 is attached to the heatsink and produces an analogue output current proportional to absolute temperature.

Each MBM device includes two orthogonal coils (X coil, Y coil) which respond to drive currents to produce a rotating magnetic field that moves the bubbles from one site to the next. Each MBM device also includes a Z coil which responds to a drive current to establish a bias field. The output of each MBM device is fed to a sense amplifier 12 which produces a logic level output based on a predetermined voltage threshold level. The threshold level is established by temperature compensation circuitry 14 which responds to the output of the sensor 10 to adjust the threshold for temperature variations. The circuitry 14 also provides a temperature compensated reference voltage to each of the function drivers 16. The drivers 16 are current sources which supply current to the various functions elements such as generate, swap, etc.

The output of the sensor 10 is converted to a digital value by the A/D converter 18 and input to microprocessor 20. Based on the operating temperature a compensation value for the X,Y,and Z coils is obtained from a Read Only Memory (ROM) look-up table in the microprocessor 20. These discrete compensation values permit an adjustment of the X and Ycoil drive currents and bias field for variations in bubble memory temperature.The compensation value for the Z-coil is converted by D/A converter 22 which provides an input voltage to current source 24 which generates the current for the Z-coil. The compensation values for the X and Y coils are converted by the D/A converter 26 and control a programmable power supply 28 connected to coil drivers 30.

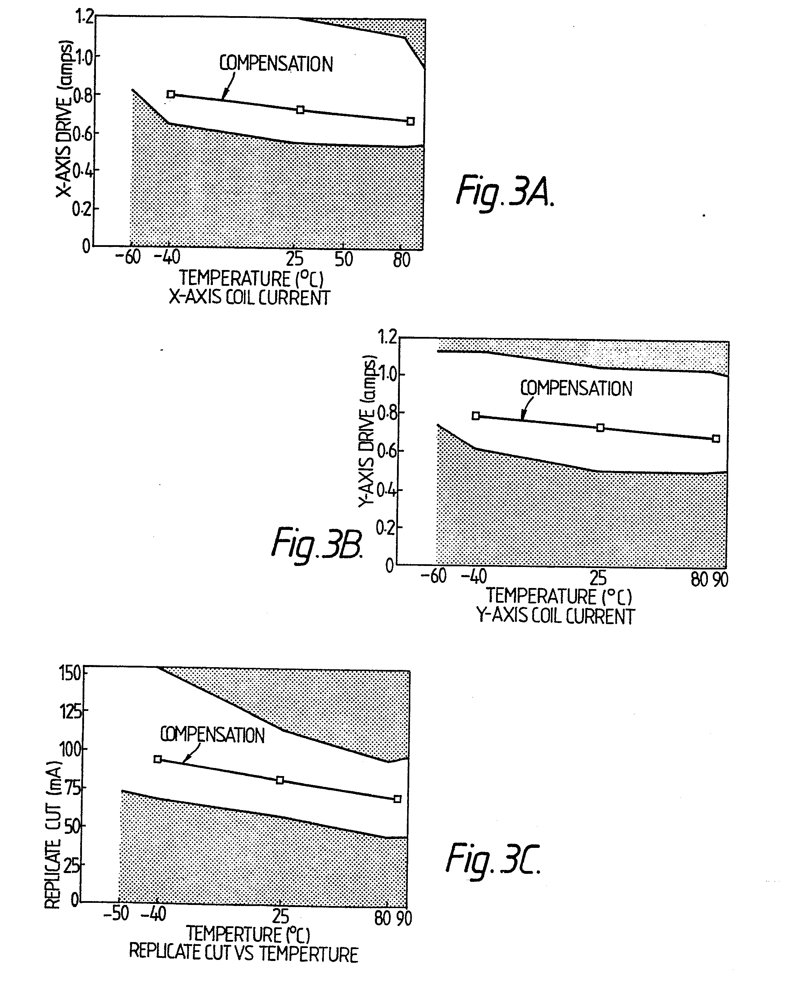

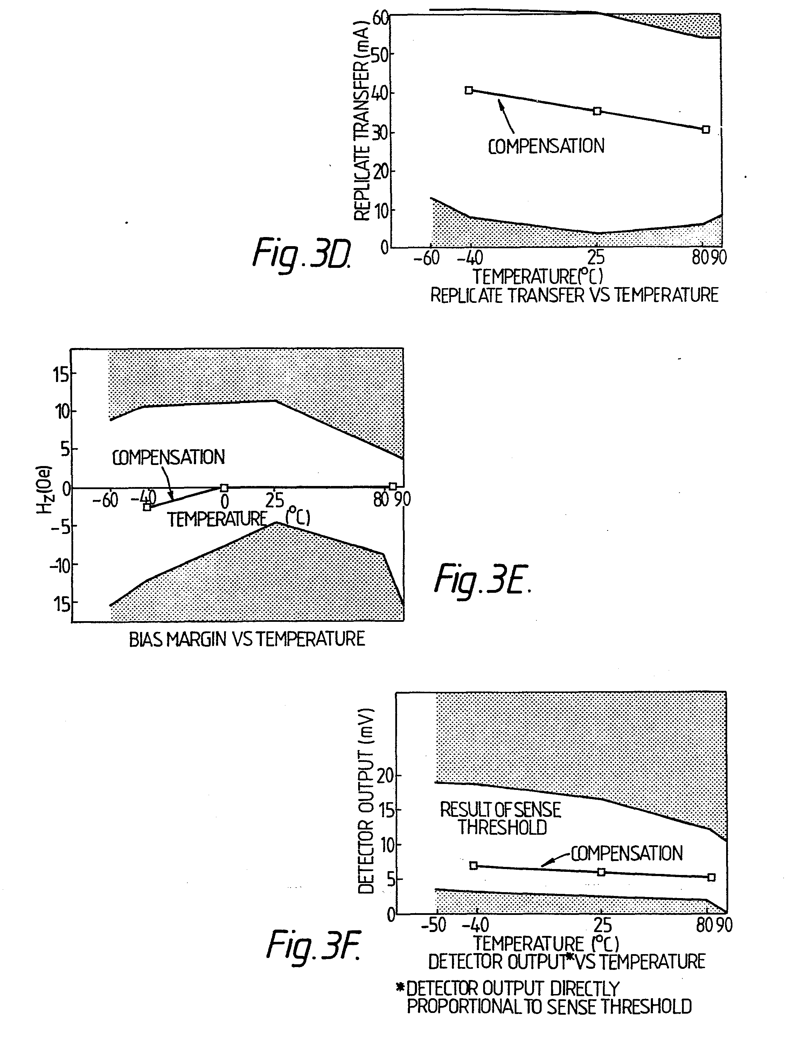

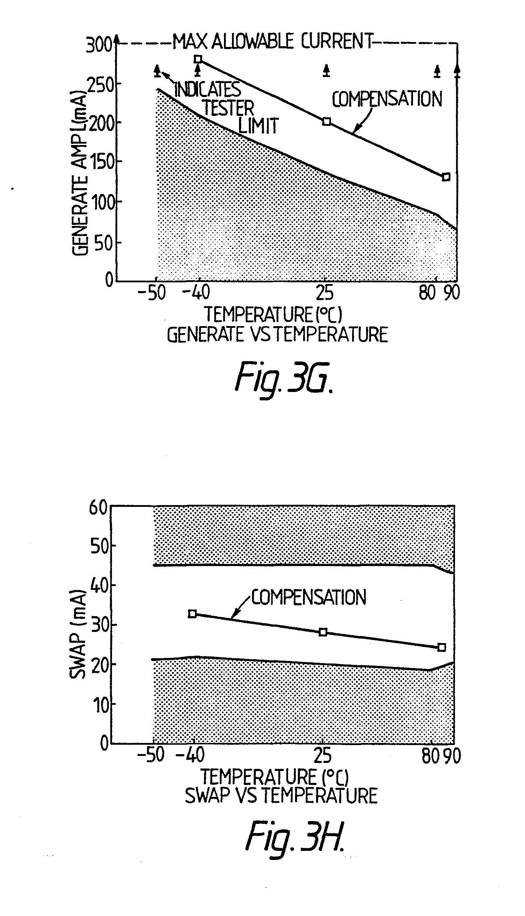

The effectiveness of the approach of the present invention is shown in Figures 3A-3H where bubble memory parameters (see Table 1) are plotted as a function of temperature. The shaded areas in each plot bound the regions of proper operation. As long as the compensation applied to all parameters lie inside the unshaded region, proper operation is assured. The dotted lines show the applied compensation for each of the values resulting from the temperature compensation technique. It is apparent that proper compensation has been achieved. It should be noted that the plots are not independent. In each case, nominal compensation is applied to the other parameters. For example, the good operating margins for the bias field would not be achieved were it not for the fact that the other parameters, particularly the drive levels,were also compensated as a function of temperature.

## TABLE 1

| PARAMETER | FUNCTION | COMMENTS |
|---|---|---|
| Bias Field | Establishes stable bubble domains. | Bias field data shown includes compensation of other parameters -- margins would be much less without these compensations. |
| Sense Threshold | Establishes bubble signal one/zero discrimination level. | Improves operating margin. |
| X Drive | Produces bubble motion. | Has a significant temperature coefficient; compensation required for wide operating temperature range. |
| Y Drive | Produces bubble motion. | Same as above. |
| Generate | Creates bubbles -- bubbles represent "one" bits; lack of a bubble represents a "zero" bit. | Must be increased at cold temperature for reliable bubble generation. |
| Swap | Transfers information from the input track to the minor (storage) loops. | Small temperature coefficient. |
| Replicate Cut | Splits the data bubble into two parts for non-destructive read-out (NDRO). | Moderate temperature coefficient. |
| Replicate Transfer | Causes one-half of the split bubble to move into the input track. | Not a temperature critical function. |

Claims:

1. A temperature compensated bubble memory system comprising a magnetic bubble memory module including at least one bubble memory device, characterised in that the system comprises a temperature sensor (10) producing an output current proportional to the temperature of said device, said device including X, Y, and Z coils, a sense amplifier (12) responsive to the output of said device and producing a logic level output based on a comparison of the output of the device with a threshold level, said device including a plurality of function elements (16), temperature compensation circuitry (14) responsive to the output of said sensor for adjusting the threshold level of said sense amplifier and the amount of current supplied to said function elements, means (20) responsive to said sensor output for determining whether the temperature of said device is within a predetermined operating range and if so providing the correct bias current to said Z coil and the correct drive currents to said X and Y coils.

2. A system as claimed in Claim 1, characterised in that the system includes means (18) for converting the output of the sensor to a digital word, and that the means (20) responsive to said sensor output comprises microprocessor means responsive to said digital word, and providing the correct bias current and drive currents as a function of said digital word.

3. A system as claimed in Claim 2, characterised in that the means (18) for converting the output of said sensor to a digital word is an analogue to digital converter.

4. A system as claimed in Claim 2 or Claim 3, characterised in that the said microprocessor means

9 · 0147968

(20) inhibits the operation of said device if
the temperature is not in said predetermined operating
range.

0147968

Fig.1.

Fig.2.

2/4

0147968

Fig.3A.

X-AXIS COIL CURRENT

COMPENSATION

Fig.3B.

Y-AXIS COIL CURRENT

Fig.3C.

REPLICATE CUT VS TEMPERTURE

0147968

Fig.3D.

REPLICATE TRANSFER VS TEMPERATURE

Fig.3E.

BIAS MARGIN VS TEMPERATURE

Fig.3F.

DETECTOR OUTPUT*VS TEMPERATURE

*DETECTOR OUTPUT DIRECTLY
PROPORTIONAL TO SENSE THRESHOLD

0147968

GENERATE VS TEMPERATURE

*Fig. 3G.*

SWAP VS TEMPERATURE

*Fig. 3H.*